# EUROPEAN PATENT SPECIFICATION

(11) **EP 1 065 502 B1**
(45) Date of publication and mention of the grant of the patent: **07.06.2006**
(21) Application number: 98929951.6
(22) Date of filing: 19.06.1998
(51) Int. Cl.: G01N 27/68, H01J 37/32, H05H 1/24, G01R 31/12

(54) **METHOD FOR ANALYZING THE BREAKDOWN CHARACTERISTICS OF A GASEOUS DIELECTRIC IN A HIGHLY NON-UNIFORM FIELD**
VERFAHREN ZUR UNTERSUCHUNG DES DURCHSCHLAGVERHALTENS EINES GASFÖRMIGEN DIELEKTRIKUMS IN EINEM STARK INHOMOGENEN FELD
PROCEDE DE ANALYSER LE CLAQUAGE ELECTRIQUE D'UN DIELECTRIQUE GAZEUX DANS UN CHAMP FORTEMENT NON UNIFORME

(30) Priority: 10.02.1998 RU 98102523
(43) Date of publication of application: 03.01.2001
(73) Proprietor: Starikov, Valery Venginovich, Novokuznetsk, 654000 (RU)
(72) Inventor: Zhuravkov, Igor Viktorovich, Moscow, 113405 (RU)
(74) Representative: Patentanwälte Zellentin & Partner
(86) International application number: PCT/RU1998/000179
(87) International publication number: WO 1998/048268

(56) References cited:
- EP-A- 0 458 505
- FR-A- 2 109 455
- RU-C- 2 008 099
- SU-A- 590 588
- SU-A- 650 127
- SU-A- 913 494
- SU-A- 1 665 855
- PATENT ABSTRACTS OF JAPAN vol. 006, no. 066 (P-112), 27 April 1982 (1982-04-27) & JP 57 007570 A (TOSHIBA CORP), 14 January 1982 (1982-01-14)
- KREUTZ E W ET AL: "HOCHFREQUENZ-FUNKENZUENDUNG EXPLOSIONSFAEHIGER ATMOSPHAEREN" ELEKTROTECHNISCHE ZEITSCHRIFT - ETZ,DE,VDE VERLAG GMBH. BERLIN, vol. 114, no. 14 / 15, 1 July 1993 (1993-07-01), pages 922-924,926-92, XP000385829 ISSN: 0948-7387
- DATABASE WPI Derwent Publications Ltd., London, GB; AN 1998-296162 XP002156848 & RU 2 095 903 A (SIDOROV A N), 10 November 1997 (1997-11-10)

## Description

### Technical field.

The invention pertains to a testing technique and is designed to be used, for example, in the research on the dielectric rigidity of high voltage equipment gaseous isolation.

### The previous technique level.

The construction of such testing equipment is connected with the necessity of making a higher voltage power supply unit with a considerably high power, which causes some difficulties in manufacturing and predetermines unsatisfactory weight and dimension characteristics of such equipment.

While implementing different technical solutions of the problem there are attempts to carry out the gaseous dielectric breakdown with a power supply unit of relatively low voltage. Among the methods providing the above mentioned effect there is the technical solution which provides injection of a hot gases in discharge gap (SU, 232358, 1101 11, 11.12.68) or gaseous bubbles of cavitation origin (SU, 1072166, H 01 T 1/20, 07.02.84), of covering one of the electrodes with a activating layer (DE, 3621254, H01 T 1/20, 07.01.88).

However, all known methods, based only on redistribution of a three dimension load within a discharge gap, are ineffective and do not allow to decrease considerably the power supply voltage.

The nearest method to the proposed one is the method for carrying out the electrical breakdown of a gaseous dielectric in a highly non-uniform field. In accordance with this method, the initial voltage, providing a self-maintained discharge, is firstly supplied to the electrodes, defining the discharge gap, and then the voltage pulse base is generated as an additional electromotive force induced in leads. Finally it results in a complete breakdown of the dielectric (SU, 913494, H01 T 3/00, 15.03.82).

The shortcoming of the prototype where the accent is made only on increasing a testing voltage with the help of the voltage pulse base is also connected with the impossibility to decrease considerably the power supply unit output voltage.

### Description of technical solution.

A technical result of the invention is carrying out the electrical breakdown of a gaseous dielectric using a power supply unit with a reduced voltage dne to the application of the both above mentioned methods at once. Namely, the preliminary redistribution of a three dimensional load and further generation of the voltage pulse in a supply circuit. This allows to carry out tests of gascous isolation and its diagnostics using a power supply unit with relatively low output voltage.

In accordance with the said method the initial voltage, sufficient for producing of a self-maintained discharge, is first supplied to the electrodes (7,8), defining a discharge gap (1) and the voltage pulse base is, then, supplied to provide together with the initial voltage the complete breakdown of the gaseous dielectric. A corona discharge is generated by supplying the initial voltage to the first electrodes, defining the discharge gap so as to ensure a three dimensional load at the corona producing electrode, Before the voltage pulse base generating, the three dimensional load is uniformly redistributed along the discharge gap by lowering the corona discharge intensity Iₖ. Simultancously, the lowering of corona discharge intensity and the formation of a voltage pulse base takes place by using a dynamic discharge device which is integrated in the supply circuit and has its second electrodes switched from a closed state into an open one before being bridged by the electrical arc.

### The list of elements illustrating the invention.

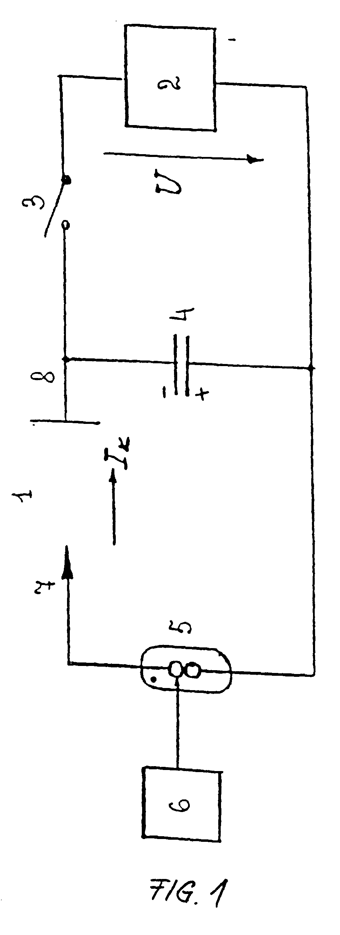

The drawing shows electrical circuit of the device, implementing the proposed method.

The device includes discharge gap 1 with electrodes, power supply unit 2, switch 3, capacitor battery 4, dynamic discharge device 5 and pusher 6. Between the electrode 7 (pin-shaped electrode) and the electrode 8 (flat-shaped electrode) there is a highly non-uniform field in which the tested gaseous dielectric is placed (it is not indicated). In the initial state the electrodes of the dynamic discharge device 5 are connected.

### The preferable version of the implementation of the above declared method.

The electrical breakdown is carried out by the following way. While turning on the switch 3 the voltage U from the power supply unit 2 through the closed dynamic discharge device 5 is supplied to the electrodes 7 and 8 of the main discharge gap 1. The initial voltage should produce a self-maintained discharge. It means that in order to convert the discharge into a self-maintained one, the initial electron avalanche should provide the creation of new electrons owing to the secondary electron producing processes.

The ionization processes are concentrated near the electrode 7 with the highest strength if the non-uniformity degree of the field is high. The three-dimensional load is generated near this electrode and the steady corona discharge with the intensity Iₖ appears in the discharge gap 1. It is necessary to mark, that corona discharge takes place at U_{AB} voltage between electrodes, which is in the interval
U₃<U_{AB}<Uₙ, where
U₃ - corona igniting voltage,
Uₗₗ - spark breakdown voltage.

Then the electrodes of the dynamic discharge device 5 are switched into an open state by the pusher 6 and the distance between them is increased. While increasing this distance, the interelectrode capacitance of the dynamic discharge device 5 is decreased and the voltage Uₐₚ of this dynamic discharge device 5 is increased. As a result the corona discharge intensity Iₖ becomes lower.

The intensity Iₖ lowering is a cause of the three dimensional load redistribution at the corona producing electrode 7. As far as ion drift along the field is decreased and the diffusion processes become prevailing, the uniform distribution of a three dimensional load along the discharge gap I takes place, resulting in its further breakdown by the voltage which is less then the breakdown voltage.

At a definite moment the field strength between the dynamic discharge device 5 and the first electrodes reaches its critical value and the electrodes of the dynamic dischage device are bridged by the electrical arc. The electrode 7 of the main discharge gap 1 is 'connected' to the corresponding power supply unit 2 output by the conducting arc formed in the dynamic discharge device 5. The voltage pulse base is generated between the electrodes 7 and 8. As a result the total voltage, sufficient for complete breakdown, is supplied to the discharge gap 1 with the uniformly distributed three dimensional load and the breakdown of a gaseous dielectric takes place. After that the electrodes of the dynamic discharge device 5 arc switched into an open state.

### Industrial application.

Thus, in order to carry out the electrical breakdown of a gaseous dielectric the following is used: 1) work of electrical field forces made in the discharge gap 1, using the power supply unit 2 energy and 2) work of mechanical forces made to switch the electrodes into an open state in the dynamic discharge device 5. The above mentioned allows to carry out gaseous isolation tests and its diagnostics with a simple method of using a power supply unit, having a relatively low output voltage.

## Claims

1. A method of electrically breaking down a gaseous dielectric in a highly non-uniform field comprising the steps of
- supplying an initial voltage to first electrodes (7, 8) which form a discharging gap (1), where said initial voltage corresponds to a condition of a self-maintaining discharge;
- while supplying the initial voltage to the discharge gap electrodes (7, 8), generating a corona discharge with the production of a three dimensional load at the corona producing electrode (7),
- uniformly redistributing said three dimensional load along the discharge gap (1) by lowering the corona discharge intensity;
- applying to said first electrodes (7, 8) a voltage pulse, which provides jointly with said initial voltage a full breakdown of said gaseous dielectric;
wherein the lowering of the corona discharge intensity and the generation of the voltage pulse is accomplished by means of a dynamic discharge device (5), which is integrated in the power supply circuit and comprises two second electrodes that are switched from a closed state into an open one and the distance between said two electrodes is increased, until they are bridged by an electrical arc.

## Patentansprüche

1. Verfahren zum elektrischen Durchbrechen eines gasförmigen Dielektrikums in einem hoch inhomogenen Feld, umfassend die Schritte:
- Anlegen einer Anfangsspannung an erste Elektroden (7, 8), die eine Entladestrecke (1) bilden, wobei die Anfangsspannung einem Zustand einer sich selbst aufrechterhaltenden Entladung entspricht;
- Erzeugen einer Koronaentladung, bei der eine dreidimensionale Last an der Korona-Erzeugenden Elektrode (7) entsteht, während die Anfangsspannung an die Elektroden (7, 8) der Entladestrecke angelegt ist,
- gleichmäßiges Umverteilen der dreidimensionalen Last entlang der Entladestrecke (1), indem die Intensität der Koronaentladung verringert wird;
- Anlegen eines Spannungspulses an die ersten Elektroden (7, 8), der zusammen mit der Anfangsspannung einen vollständigen Durchbruch des gasförmigen Dielektrikums bewirkt;
wobei das Verringern der Intensität der Koronaentladung und die Erzeugung des Spannungspulses mittels einer dynamischen Entladeeinrichtung (5) durchgeführt wird, die im Energieversorgungskreis integriert ist und zwei zweite Elektroden umfasst, die aus einem geschlossenen in einen offenen Zustand geschaltet werden, wobei der Abstand zwischen den beiden Elektroden vergrößert wird, bis sie von einem elektrischen Lichtbogen überbrückt werden.

## Revendications

1. Procédé de claquage électrique d'un diélectrique gazeux dans un champ hautement non uniforme, comprenant les étapes de:
- application d'une tension initiale sur des premières électrodes (7, 8) qui forment un espace de décharge (1), où ladite tension initiale correspond à une condition d'une décharge d'auto-soutien;
- tout en appliquant la tension initiale sur les électrodes d'espace de décharge (7, 8), génération d'une décharge corona moyennant la production d'une charge tridimensionnelle au niveau de l'électrode de production de corona (7);
- redistribution de façon uniforme de ladite charge tridimensionnelle le long de l'espace de décharge (1) en abaissant l'intensité de décharge corona;
- application sur lesdites premières électrodes (7, 8) d'une impulsion de tension, ce qui assure de façon conjointe avec ladite tension initiale un claquage complet dudit diélectrique gazeux,
dans lequel l'abaissement de l'intensité de décharge corona et la génération de l'impulsion de tension sont réalisés au moyen d'un dispositif de décharge dynamique (5) qui est intégré dans le circuit d'alimentation et qui comprend deux secondes électrodes qui sont commutées depuis un état fermé dans un état ouvert et la distance entre lesdites deux électrodes est augmentée, jusqu'à ce qu'elles soient pontées par un arc électrique.
